(19) **Europäisches Patentamt European Patent Office Office européen des brevets**

(11) **EP 4 439 081 B1**

(12) **EUROPEAN PATENT SPECIFICATION**

(45) Date of publication and mention of the grant of the patent:
**29.10.2025 Bulletin 2025/44**

(21) Application number: **21965676.6**

(22) Date of filing: **26.11.2021**

(51) International Patent Classification (IPC):
*G01R 1/20* (2006.01)    *G01R 19/00* (2006.01)
*H05K 1/02* (2006.01)

(52) Cooperative Patent Classification (CPC):
**G01R 1/203; G01R 19/0053; H05K 1/0228;**
H05K 2201/09236; H05K 2201/09245;
H05K 2201/09672; H05K 2201/097

(86) International application number:
**PCT/JP2021/043468**

(87) International publication number:
**WO 2023/095306 (01.06.2023 Gazette 2023/22)**

(54) **DETECTION CIRCUIT**

DETEKTIONSSCHALTUNG

CIRCUIT DE DÉTECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.10.2024 Bulletin 2024/40**

(73) Proprietor: **MITSUBISHI ELECTRIC CORPORATION**
**Chiyoda-ku**
**Tokyo 100-8310 (JP)**

(72) Inventors:
• **MURAKAMI, Satoshi**
**Tokyo 100-8310 (JP)**
• **NAKAGAWA, Akira**
**Tokyo 100-8310 (JP)**
• **SAITO, Masatoshi**
**Tokyo 100-8310 (JP)**
• **NAGAO, Takashi**
**Tokyo 100-8310 (JP)**
• **NAGARE, Toshiki**
**Tokyo 100-8310 (JP)**

(74) Representative: **Hoffmann Eitle**
**Patent- und Rechtsanwälte PartmbB**
**Arabellastraße 30**
**81925 München (DE)**

(56) References cited:
| | |
|---|---|
| WO-A1-2019/167244 | WO-A1-2019/171997 |
| WO-A1-2019/202730 | CN-B- 110 383 666 |
| DE-T5- 112019 004 609 | JP-A- 2002 191 179 |
| JP-A- 2003 014 792 | JP-A- 2003 114 243 |
| JP-A- 2005 156 353 | JP-A- 2015 002 333 |
| JP-A- 2015 017 832 | JP-A- 2015 194 460 |
| JP-A- 2019 045 254 | JP-A- 2020 046 207 |
| JP-A- 2020 159 956 | US-A1- 2016 356 825 |
| US-A1- 2017 023 623 | |

**Description**

TECHNICAL FIELD

The present disclosure relates to a detection circuit for detecting current or voltage.

BACKGROUND ART

In a conventional current detection circuit, a resistor is interposed on a current path through which main current flows during circuit operation, and a current value is obtained on the basis of voltage generated between both ends of the resistor when current flows through the resistor. Such a resistor is also called a shunt resistor. The current detection circuit using the shunt resistor has an advantage that the circuit configuration can be simplified. In the current detection circuit using the shunt resistor, the voltage generated between both ends of the resistor is inputted to a differential amplifier so as to be combined, thus reducing interference voltages which are the influence of electromagnetic noise interfering in the same phase. However, the interference voltages inputted together when the voltage generated between both ends of the resistor is inputted to the differential amplifier are not actually at the same level, and a difference between the interference voltages is detected at an output from the differential amplifier, thus hampering accurate detection for current. Regarding this problem, in order to accurately detect current without being influenced by interference from electromagnetic noise, it has been disclosed that two current detection circuits each composed of a shunt resistor, a current detection wire, and a differential amplifier, are provided, interference voltages at the same level are generated on the two circuits, and outputs from the two circuits are inputted to another differential amplifier, thus canceling out the influence of electromagnetic noise (for example, Patent Document 1).

CITATION LIST

PATENT DOCUMENT

Patent Document 1: Japanese Patent No. 6254977
The document DE 11 2019 004609 T5 discloses a current detection circuit comprising a shunt resistor connected to a differential amplifier by means of wiring formed in a multilayer board.

SUMMARY OF THE INVENTION

PROBLEM TO BE SOLVED BY THE INVENTION

In the above current detection circuit, it is necessary to provide two current detection circuits each composed of a shunt resistor, a current detection wire, and a differential amplifier, and provide another differential amplifier for processing current detection outputs from the two circuits, thus having problems such as increase in the manufacturing cost due to addition of a component and a circuit, and increase in a circuit area where components are mounted.

The present disclosure has been made to solve the above problem, and an object of the present disclosure is to provide a detection circuit which accurately detects current or voltage by reducing the influence of interference with electromagnetic noise, while decreasing addition of a component and a circuit as compared to conventional art.

MEANS TO SOLVE THE PROBLEM

A detection circuit according to the present disclosure includes: a detector interposed on a path of current or voltage in an electric circuit; a differential amplifier which outputs voltage according to the current or the voltage detected by the detector; a plus-side detection wire connected between a plus input terminal of the differential amplifier and one end of both ends at which the detector is connected to the path; a minus-side detection wire connected between a minus input terminal of the differential amplifier and another end of both ends at which the detector is connected to the path; at least one first detection wire connected in parallel to at least a part of the plus-side detection wire between the one end of the detector and the plus input terminal of the differential amplifier; and at least one second detection wire connected in parallel to at least a part of the minus-side detection wire between the other end of the detector and the minus input terminal of the differential amplifier. The first detection wire and the second detection wire are arranged in the electric circuit so as to, by induced voltages generated due to external electromagnetic noise, cancel out induced voltages generated on the plus-side detection wire and the minus-side detection wire due to the electromagnetic noise.

EFFECT OF THE INVENTION

The present disclosure provides, in a detection circuit, an effect of reducing the influence of interference from electromagnetic noise, while decreasing addition of a component and a circuit as compared to conventional art.

BRIEF DESCRIPTION OF THE DRAWINGS

[FIG. 1] FIG. 1 is a schematic diagram schematically showing a configuration example of a detection circuit according to embodiment 1 of the present disclosure.
[FIG. 2] FIG. 2 is a schematic diagram schematically illustrating the heights of induced voltages generated on detection wires due to interference with electromagnetic noise.
[FIG. 3] FIG. 3 is a configuration diagram illustrating a configuration in which pairs of detection wires of which the polarities of difference voltages are different are arranged using a multilayer board.
[FIG. 4] FIG. 4 is a schematic diagram schematically showing a configuration example in which detection wires of the detection circuit are arranged at a plurality of wiring layers of the multilayer board.
[FIG. 5] FIG. 5 is a configuration diagram schematically showing a configuration example in which detection wires of the detection circuit are arranged at the same layer of the board.
[FIG. 6] FIG. 6 is a configuration diagram showing a configuration example in which a detection circuit is mounted to an inverter, according to embodiment 2 of the present disclosure.
[FIG. 7] FIG. 7 is a configuration diagram showing a configuration example in which a detection circuit is mounted to a boost converter, according to embodiment 3 of the present disclosure.

DESCRIPTION OF EMBODIMENTS

In a configuration of the present disclosure, a detection circuit incorporated in an electric circuit and using a resistor as a detector is a current detection circuit, and a detection circuit incorporated in an electric circuit and using a capacitor as a detector is a voltage detection circuit. The voltage detection circuit configured as described above detects DC voltage stored in the capacitor and is capable of detecting voltage even in a state in which current does not flow through the capacitor.
Hereinafter, in the present disclosure, the current detection circuit using a resistor as a detector is described as an example. However, the voltage detection circuit using a capacitor as a detector may be applied, that is, the current detection circuit and the voltage detection circuit are included in the scope of the present disclosure. In a case of not discriminating the current detection circuit and the voltage detection circuit from each other, they are both referred to as a detection circuit.

Embodiment 1

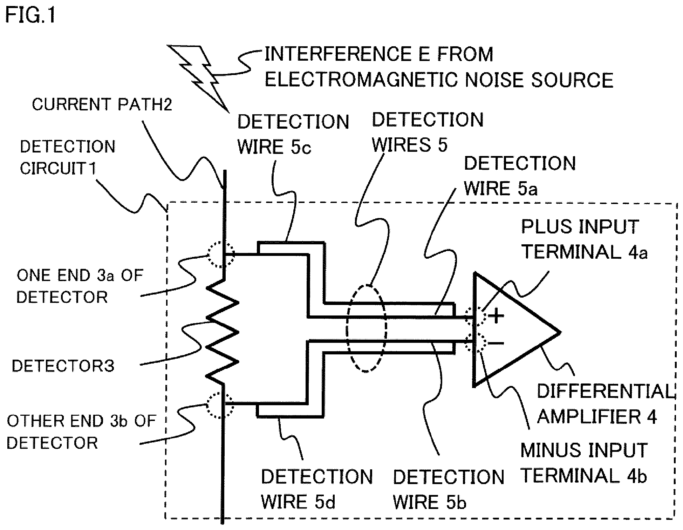

FIG. 1 is a schematic diagram schematically showing a configuration example of a detection circuit 1 according to embodiment 1 of the present disclosure. Hereinafter, description will be given using the current detection circuit as an example of the detection circuit 1.
The detection circuit 1 includes a current path 2 of an electric circuit, a detector 3 interposed on the current path 2, a differential amplifier 4, a detection wire 5a (plus-side detection wire) connecting a plus input terminal 4a (+ input terminal) which is an input part of the differential amplifier 4 and one end 3a of the detector 3, a detection wire 5b (minus-side detection wire) connecting a minus input terminal 4b (- input terminal) which is an input part of the differential amplifier 4 and another end 3b of the detector 3, a detection wire 5c connected in parallel to at least a part of the detection wire 5a between the plus input terminal 4a (+ input terminal) of the differential amplifier 4 and the one end 3a of the detector 3, and a detection wire 5d connected in parallel to at least a part of the detection wire 5b between the minus input terminal 4b (-input terminal) of the differential amplifier 4 and the other end 3b of the detector 3. Hereinafter, a plurality of the detection wires (in FIG. 1, detection wires 5a to 5d) may be collectively referred to as detection wires 5.
The detection wires 5 may include circuit components for making electric connection.
The detection circuit 1 detects or measures voltage generated between both ends of the detector 3 (i.e., between the one end 3a and the other end 3b of the detector 3), by an output of the differential amplifier 4, to detect current flowing through the detector 3, and also to derive a current value thereof and obtain various information such as change in the current.
The detector 3 is a resistor for inputting current of the current path 2 which is a detection or measurement target, as voltage, to the differential amplifier 4.

In the present disclosure, a current path refers to a path through which main current flows when the electric circuit operates. A voltage path refers to a path through which main current does not flow in circuit operation, as for voltage of the capacitor interposed between a power supply and a GND (ground), for example.

In the present disclosure, the configuration example of the detection circuit 1 is described using the current path 2, and meanwhile, both of the current path and the voltage path may be collectively referred to as a path 2.

The detector 3 is a circuit component that generates voltage according to a physical quantity (i.e., current or voltage) that is a detection or measurement target on the path 2, and is formed by a resistor, a capacitor, or the like in accordance with a purpose of detection or measurement.

When the detection circuit 1 is subjected to interference E from an external electromagnetic noise source, if the position relationships between the noise source and the respective detection wires 5a to 5d are equal to each other, induced voltages (which are the same as interference voltages; hereinafter, the same applies) at the same level are generated on the detection wires 5a to 5d, but if the position relationships between the noise source and the respective detection wires 5a to 5d are different from each other, different induced voltages are generated on the detection wires 5a to 5d.

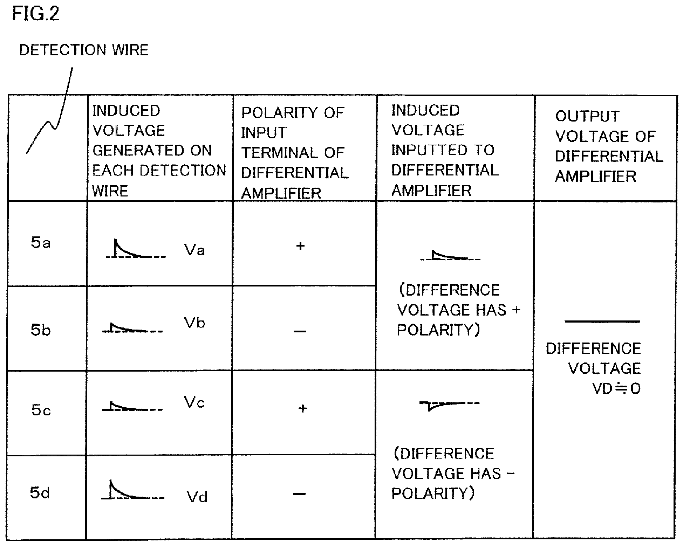

FIG. 2 is a schematic diagram schematically illustrating the heights of the induced voltages generated on the detection wires 5a to 5d due to interference of electromagnetic noise. In a conventional detection circuit 1, detection wires 5 between the detector 3 and the differential amplifier 4 are formed by two detection wires 5a and 5b respectively connected to a pair of the plus input terminal 4a (+ input terminal) and the minus input terminal 4b (- input terminal) of the differential amplifier 4.

Here, if the position relationships between the noise source and the respective detection wires 5a and 5b are different from each other, different induced voltages are generated on the detection wires 5a and 5b, so that voltage corresponding to a difference between the induced voltages generated on the detection wires 5a and 5b is outputted from the differential amplifier 4. As a result, accuracy of detection for current by the detection circuit 1 is influenced.

Hereinafter, a method for reducing the difference between the induced voltages generated on the detection wires 5a and 5b will be described.

Here, for simplifying description, the induced voltages generated on the detection wires 5a and 5b are denoted as induced voltage Va and induced voltage Vb, and it is assumed that the induced voltage Va > the induced voltage Vb is satisfied in the position relationships between the noise source and the respective detection wires 5a and 5b.

As shown in FIG. 1, in addition to the pair of detection wires 5a and 5b, another pair of detection wires 5c and 5d are provided between the detector 3, and the plus input terminal 4a (+ input terminal) and the minus input terminal 4b (- input terminal) of the differential amplifier 4. The detection wire 5c is connected in parallel to the detection wire 5a, between the plus input terminal 4a (+ input terminal) of the differential amplifier 4 and the one end 3a of the detector 3, and the detection wire 5d is connected in parallel to the detection wire 5b, between the minus input terminal 4b (- input terminal) of the differential amplifier 4 and the other end 3b of the detector 3.

Here, where the respective induced voltages generated on the detection wires 5c and 5d are denoted as induced voltage Vc and induced voltage Vd, wiring is made in the electric circuit with such arrangement that satisfies the induced voltage Vd > the induced voltage Vc in the position relationships between the noise source and the detection wires 5c and 5d.

Further, difference voltage between the induced voltage generated on the detection wire 5 connected to the plus input terminal 4a of the differential amplifier 4 and the induced voltage generated on the detection wire 5 connected to the minus input terminal 4b of the differential amplifier 4 is calculated.

At this time, a plurality of pairs composed of each of the detection wires 5 connected to the plus input terminal 4a of the differential amplifier 4 and each of the detection wires 5 connected to the minus input terminal 4b of the differential amplifier 4, are specified. Then, regarding each specified pair of the detection wires 5, voltage obtained by subtracting the induced voltage generated on the detection wire 5 connected to the minus input terminal 4b from the induced voltage generated on the detection wire 5 connected to the plus input terminal 4a is calculated.

Specifically, in FIG. 1 and FIG. 2, regarding the detection wires 5a and 5b as a pair, the polarity of voltage corresponding to a difference when the induced voltage Vb generated on the detection wire 5 connected to the minus input terminal 4b of the differential amplifier 4 is subtracted from the induced voltage Va generated on the detection wire 5 connected to the plus input terminal 4a of the differential amplifier 4 (i.e., induced voltage Va - induced voltage Vb), is a plus polarity (+ polarity) from a relationship of the induced voltage Va > the induced voltage Vb. Hereinafter, the voltage corresponding to the difference between the induced voltages Va and Vb is denoted as difference voltage VDab.

Similarly, regarding the detection wires 5c and 5d as a pair, the polarity of voltage corresponding to a difference when the induced voltage Vd generated on the detection wire 5 connected to the minus input terminal 4b of the differential amplifier 4 is subtracted from the induced voltage Vc generated on the detection wire 5 connected to the plus input terminal 4a of the differential amplifier 4 (i.e., induced voltage Vc - induced voltage Vd), is a minus polarity (- polarity) from a relationship of the induced voltage Vd > the induced voltage Vc. Hereinafter, the voltage corresponding to the difference between the induced voltages Vc and Vd is denoted as difference voltage VDcd.

Here, arrangement of the detection wires 5c and 5d is calculated so that the difference voltage VDcd of the detection wires 5c and 5d has an absolute value equal to and a sign different from the absolute value of the difference voltage VDab, and the detection wires 5c and 5d are thus arranged in the electric circuit.

As described above, the difference voltages VDab and VDcd between the pair of detection wires 5a and 5b and between the pair of detection wires 5c and 5d are set to be different in polarity and equal in absolute value, whereby, when the difference voltages VDab and VDcd are inputted to the differential amplifier 4, the induced voltages Va to Vd generated on the detection wires 5a to 5d are canceled out with each other in the differential amplifier 4. This can also be described as a cancellation effect being exerted among the induced voltages Va to Vd. As a result, difference voltage between the induced voltages included in the output of the differential amplifier 4 in the conventional detection circuit 1 is reduced, whereby it becomes possible to accurately detect current in the detection circuit 1.

Induced voltage generated on the detection wire 5 due to interference of electromagnetic noise is an induced electromotive force and is caused, as voltage, mainly by change per unit time in a magnetic flux interlinked with the detection wire 5 from the noise source. Therefore, the induced voltage can be expressed irrespective of current.

This is shown in Expression 1. Considering Expression 1, it is desirable that the detection wires 5a to 5d are arranged so that difference voltage included in the output of the differential amplifier 4 becomes close to zero.
[Mathematical 1]

$$Vn \sim d\varphi/dt \quad \ldots \quad (\text{Expression 1})$$

Here, Vn and $d\varphi$ are as follows.

Vn: an induced electromotive force generated on the detection wire 5
$d\varphi$: a magnetic flux interlinked with the detection wire 5 from the noise source
$d\varphi/dt$: change per unit time in a magnetic flux interlinked with the detection wire from the noise source

Further, the detection wires 5c and 5d may each include at least one detection wire, and each detection wire included in the detection wire 5c may be set to be paired with each detection wire included in the detection wire 5d. In this case, the total number of the detection wires 5a to 5d is a multiple of 2.

Among the detection wires 5 of the detection circuit 1, the induced voltage generated on each detection wire 5 is biased due to the position relationship with the external electromagnetic noise, so that detection accuracy for current or voltage is lowered and control of the electric circuit is likely to be unbalanced. Regarding such a problem, the above-described configuration is adopted, whereby it is possible to cancel out the biases of the induced voltages generated on the respective detection wires 5 and suppress lowering of detection accuracy, merely by increasing the detection wires 5 of the detection circuit 1 without newly providing electric components, as compared to conventional art.

That is, the detection circuit 1 of the present disclosure can be expressed as including: a detector 3 interposed on a path 2 of current or voltage in an electric circuit; a differential amplifier 4 which outputs voltage according to the current or the voltage detected by the detector 3; a plus-side detection wire 5a connected between a plus input terminal 4a of the differential amplifier 4 and one end 3a of both ends at which the detector 3 is connected to the path 2 for the current or the voltage in the electric circuit; a minus-side detection wire 5b connected between a minus input terminal 4b of the differential amplifier 4 and another end 3b of both ends; at least one first detection wire 5c connected in parallel to at least a part of the plus-side detection wire 5a between the one end 3a of the detector 3 and the plus input terminal 4a of the differential amplifier 4; and at least one second detection wire 5d connected in parallel to at least a part of the minus-side detection wire 5b between the other end of the detector 3 and the minus input terminal 4b of the differential amplifier 4, wherein the first detection wire 5c and the second detection wire 5d are arranged in the electric circuit so as to, by induced voltages generated due to external electromagnetic noise, cancel out induced voltages generated on the plus-side detection wire 5a and the minus-side detection wire 5b due to the electromagnetic noise.

In addition, in the detection circuit 1 of the present disclosure, it can be expressed that each detection wire included in the first detection wire 5c is paired with each detection wire included in the second detection wire 5d, and a total number of the plus-side detection wire 5a, the minus-side detection wire 5b, the first detection wire 5c, and the second detection wire 5d is a multiple of 2.

In addition, in the detection circuit 1 of the present disclosure, it can be expressed that the first detection wire 5c and the second detection wire 5d are arranged so that output voltage obtained by the differential amplifier 4 combining first difference voltage VDab which is a difference between the induced voltages on the plus-side detection wire 5a and the minus-side detection wire 5b and second difference voltage VDcd which is a difference between the induced voltages on the first detection wire and the second detection wire, becomes 0.

In addition, in the detection circuit 1 of the present disclosure, it can be expressed that, in a case where the detector 3 is a resistor, the detection circuit 1 operates as a current detection circuit which detects or measures a value of current or voltage present in a main circuit to which the resistor is electrically connected, on the basis of voltage generated between both ends of the resistor when current flows therethrough. The resistor in this case is also called a shunt resistor.

In addition, in the detection circuit 1 of the present disclosure, it can be expressed that, in a case where the detector 3 is a capacitor, the detection circuit 1 operates as a voltage detection circuit which detects or measures a value of current or voltage present in a main circuit to which the capacitor is electrically connected, on the basis of voltage stored in the capacitor.

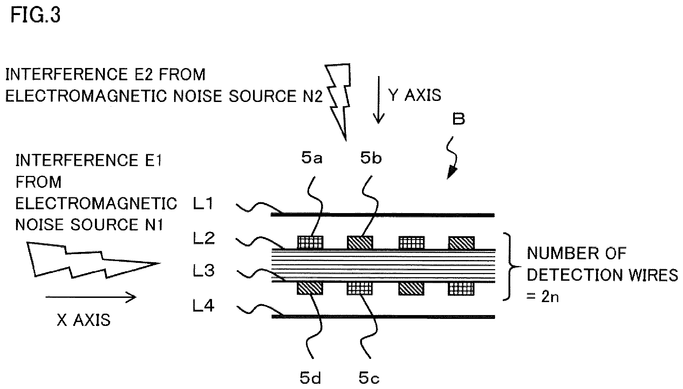

FIG. 3 is a configuration diagram illustrating a configuration in which pairs of detection wires of which the polarities of difference voltages are different are arranged using a multilayer board.

In FIG. 3, description will be given using a four-layer board B as an example of the multilayer board. For facilitating description, a first layer surface L1 of the four-layer board B may be referred to as a 1/4 layer, a second layer surface L2 may be referred to as a 2/4 layer, a third layer surface L3 may be referred to as a 3/4 layer, and a fourth layer surface L4 may be referred to as a 4/4 layer.

As shown in FIG. 3, a direction parallel to the board surface is defined as an X-axis direction, and a direction from left to right in the X-axis direction is defined as a positive direction of the X axis. A direction perpendicular to the board surface is defined as a Y-axis direction, and a direction from up to down in the Y-axis direction is defined as a positive direction of the Y axis.

As shown in FIG. 3, the detection wires 5a and 5b are provided at the 2/4 layer, and the detection wires 5c and 5d are provided at the 3/4 layer. At this time, at the same layer, the wire connected to the plus input terminal 4a (+ input terminal) of the differential amplifier 4 and the wire connected to the minus input terminal 4b (- input terminal) are arranged so as to be adjacent to each other, and at different layers, the wire connected to the input terminal 4a (+ input terminal) of the differential amplifier 4 and the wire connected to the minus input terminal 4b (- input terminal) are arranged so as to be opposed to each other. Here, at the 2/4 layer, the detection wires 5a and 5b connected to the respective input terminals 4a and 4b having different polarities, of the differential amplifier 4, are arranged so as to be adjacent to each other. At the 3/4 layer, the detection wires 5c and 5d connected to the respective input terminals 4a and 4b having different polarities, of the differential amplifier 4, are arranged so as to be adjacent to each other. At the 2/4 layer and the 3/4 layer, the detection wires 5a and 5d, and the detection wires 5b and 5c, connected to the respective input terminals 4a and 4b having different polarities, of the differential amplifier 4, are arranged so as to be respectively opposed to each other. That is, focusing on the two polarities of the plus input terminal 4a and the minus input terminal 4b of the differential amplifier 4, the detection wires 5a to 5d arranged at the 2/4 layer and the 3/4 layer of the four-layer board B appear in a staggered form in a cross-section.

Further, like the pair of detection wires 5a and 5b for detecting or measuring a physical quantity of the detector 3 and the pair of detection wires 5c and 5d additionally connected in parallel to the respective detection wires 5a and 5b, the detection wires 5 of the detection circuit 1 are arranged such that the number of the wires is a multiple of 2. Therefore, in the example in FIG. 3, at the 2/4 layer and the 3/4 layer of the four-layer board B, 2n detection wires 5 including the detection wires 5a to 5d are arranged as pairs. Here, n is a positive number.

Next, a case where interferences of electromagnetic noises come in the positive directions of the X axis and the Y axis to the detection wires 5a to 5d arranged in the four-layer board B shown in FIG. 3, will be described. In FIG. 3, as an example of interference of electromagnetic noise, it is assumed that there are interference E1 in the positive direction of the X axis from an electromagnetic noise source N1 and interference E2 in the positive direction of the Y axis from an electromagnetic noise source N2.

In general, the induced voltage generated on the detection wire 5 is greater at a position closer to the noise source. Therefore, in the X-axis direction, "the induced voltage Va on the detection wire 5a > the induced voltage Vb on the detection wire 5b" and "the induced voltage Vd on the detection wire 5d > the induced voltage Vc on the detection wire 5c" are satisfied.

As in the method for calculating the difference voltage between the induced voltages generated on the pair of detection wires 5 as described in FIG. 2, the polarity of the difference voltage VDab between the pair of the detection wires 5a and 5b is a plus polarity (+ polarity), and the polarity of the difference voltage VDcd between the pair of detection wires 5c and 5d is a minus polarity (- polarity).

Thus, when the induced voltages Va to Vd on the detection wires 5a to 5d arranged in the X-axis direction are inputted to the differential amplifier 4, the differential amplifier 4 can output voltage in which the induced voltages Va to Vd as an influence of the electromagnetic noise on the detection wires 5a to 5d are combined and canceled out with each other. That is, with respect to the X-axis direction, by arranging the detection wires 5 as shown in FIG. 3, the induced voltages Va to Vd are canceled out by being combined in the differential amplifier 4, whereby the influence of the interference E1 on the output voltage can be made zero.

Where the output voltage obtained by the differential amplifier 4 combining the induced voltages Va to Vd generated on the detection wires 5a to 5d due to the interference E1 in the X-axis direction as described above is denoted by Vo1, Vo1 is represented by the following Expression 2.

[Mathematical 2] Induced voltage (Va) on detection wire 5a - induced voltage (Vb) on detection wire 5b = difference voltage VDab (VDab: assumed to be a positive value "+V1") Induced voltage (Vc) on detection wire 5c - induced voltage (Vd) on detection wire 5d = difference voltage VDcd (VDcd: assumed to be a negative value "-V1") Output voltage (Vo1) = [induced voltage (Va) on detection wire 5a - induced voltage (Vb) on detection wire 5b] + [induced voltage (Vc) on detection wire 5c - induced voltage (Vd) on detection wire 5d] = difference voltage VDab + difference voltage VDcd = +V1 + (-V1) = 0

(Expression 2)

The output voltage (Vo1) can also be represented by Expression 3.
[Mathematical 3] Output voltage (Vo1) = induced voltage on detection wire 5a - induced voltage on detection wire 5b + induced voltage on detection wire 5c - induced voltage on detection wire 5d = 0

(Expression 3)

Also for the Y-axis direction, similarly, "the induced voltage Va on the detection wire 5a > the induced voltage Vd on the detection wire 5d" and "the induced voltage Vb on the detection wire 5b > the induced voltage Vc on the detection wire 5c" are satisfied.

As in the method for calculating the difference voltage between the induced voltages generated on the pair of detection wires 5 as described in FIG. 2, the polarity of the difference voltage VDad between the pair of detection wires 5a and 5d is a plus polarity (+ polarity), and the polarity of the difference voltage VDcb between the pair of detection wires 5b and 5c is a minus polarity (- polarity).

Thus, when the induced voltages Va to Vd on the detection wires 5a to 5d arranged in the Y-axis direction are inputted to the differential amplifier 4, the differential amplifier 4 can output voltage in which the induced voltages Va to Vd as an influence of the electromagnetic noise on the detection wires 5a to 5d are combined and canceled out with each other. That is, with respect to the Y-axis direction, by arranging the detection wires 5 as shown in FIG. 3, the induced voltages Va to Vd are canceled out by being combined in the differential amplifier 4, whereby the influence of the interference E2 on the output voltage can be made zero.

Where the output voltage obtained by the differential amplifier 4 combining the induced voltages Va to Vd generated on the detection wires 5a to 5d due to the interference E2 in the Y-axis direction as described above is denoted by Vo2, Vo2 is represented by the following Expression 4.
[Mathematical 4] Induced voltage (Va) on detection wire 5a - induced voltage (Vd) on detection wire 5d = difference voltage VDad (VDad: assumed to be a positive value "+V2") Induced voltage (Vc) on detection wire 5c - induced voltage (Vb) on detection wire 5b = difference voltage VDcb (VDcb: assumed to be a negative value "-V2") Output voltage (Vo2) = [induced voltage (Va) on detection wire 5a - induced voltage (Vd) on detection wire 5d] + [induced voltage (Vc) on detection wire 5c - induced voltage (Vb) on detection wire 5b] = difference voltage VDad + difference voltage VDcb = +V2 + (-V2) = 0

(Expression 4)

The output voltage (Vo2) can also be represented by Expression 5.
[Mathematical 5] Output voltage (Vo2) = induced voltage on detection wire 5a - induced voltage on detection wire 5d + induced voltage on detection wire 5c - induced voltage on detection wire 5b = induced voltage on detection wire 5a - induced voltage on detection wire 5b + induced voltage on detection wire 5c - induced voltage on detection wire 5d = 0

(Expression 5)

According to Expressions 2 and 4, with the configuration made as shown in FIG. 2, respective components of the induced voltages generated on the detection wires 5a to 5d are inputted to the differential amplifier 4 and thus are cancelled out with each other to be zero, with respect to both of the interference E1 in the X-axis direction and the interference E2 in the Y-axis direction.

According to Expressions 3 and 5, it is found that the output voltages Vo1 and Vo2 are in equivalent relationships using the detection wires 5a to 5d.

That is, the direction in which the electromagnetic noise causes interference can be considered while being decomposed into the horizontal direction (X-axis direction) of the board surface of the multilayer board and the direction (Y-axis direction) perpendicular to the board surface, and therefore, in no matter which direction with respect to the multilayer board the electromagnetic noise interferes, the output is made while the influences of the induced voltages generated on the detection wires 5 are canceled out with each other in the differential amplifier 4, as described above.

Thus, it can be said that the structure of the detection wires 5a to 5d arranged in the multilayer board as shown in FIG. 3 has an effect of canceling out influences of interference of electromagnetic noise.

Further, depending on the way of arranging the detection wires 5 of the detection circuit 1, a cancellation effect is exerted with respect to the influences of interferences from a plurality of noise sources present inside and outside the board of the electric circuit, whereby the influences of the noise sources can be reduced.

In order to reduce the influence of interference from electromagnetic noise on the detection circuit 1, it is desirable to arrange the detection wires 5 in the above-described manner while considering the arrangement positions of the detector 3 and the differential amplifier 4 in the detection circuit 1 mounted to the electric circuit, the specifications of the circuit board, the number of wires and a wiring space that are permitted in terms of designing, and the like.

In FIG. 1 to FIG. 3, the example in which there are four detection wires 5 has been described. However, in mounting of the detection circuit 1 to the electric circuit, it suffices that a plurality of pairs of detection wires 5 can be arranged between the detector 3 and the differential amplifier 4 so that the sum of difference voltages of the respective pairs becomes zero. Therefore, if the number of the detection wires 5 arranged in the electric circuit is set at a multiple of 2 (i.e., 2n; n is a positive number), the detection wires 5 can form n pairs.

The layers where the detection wires 5 of the detection circuit 1 are arranged are not limited to the 2/4 layer and the 3/4 layer in the example shown in FIG. 3. In addition, the layers where the detection wires 5 are arranged are not limited to adjacent layers of the multilayer board, and may be layers with one or more layers interposed therebetween. That is, in the example in FIG. 3, the detection wires 5 may be arranged at the 2/4 layer and the 4/4 layer.

The number of layers of the multilayer board may be arbitrary, and a six-layer board, an eight-layer board, or the like may be adopted. The multilayer board applicable here is a board having a plurality of board surfaces where wiring can be made, and may be a both-surface board. With the front and back surfaces of the both-surface board regarded as two layers that are a 1/2 layer and a 2/2 layer, the detection wires 5 may be arranged in accordance with the above-described configuration, in mounting the detection circuit 1 on the front and back surfaces of the both-surface board.

That is, in the detection circuit 1 of the present disclosure, it can be expressed that, at the same layer of the multilayer board, each detection wire 5 included in the plus-side detection wire 5a and the first detection wire 5c is arranged so as to be adjacent to any of detection wires 5 included in the minus-side detection wire 5b and the second detection wire 5d, and at different layers of the multilayer board, each detection wire 5 included in the plus-side detection wire 5a and the first detection wire 5c is arranged so as to be opposed to any of detection wires 5 included in the minus-side detection wire 5b and the second detection wire 5d.

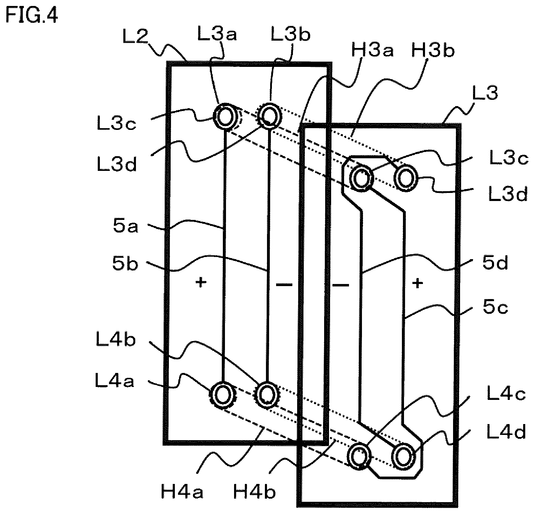

FIG. 4 is a schematic diagram schematically showing a configuration example in which the detection wires 5 of the detection circuit 1 are arranged at a plurality of wiring layers of the multilayer board. Description will be given using the four-layer board B as an example of the multilayer board.

Among the wiring layers of the four-layer board B, at the 2/4 layer (second layer surface L2), the detection circuit 1 has lands L3a and L3b at the one end 3a and the other end 3b of the detector 3 and has lands L4a and L4b at the plus input terminal (+ input terminal) and the minus input terminal (- input terminal) of the differential amplifier 4. Then, the detection wire 5a connects the land L3a on the detector 3 side and the land L4a on the differential amplifier 4 side without detouring around a land, and the detection wire 5b connects the land L3b on the detector 3 side and the land L4b on the differential amplifier 4 side without detouring around a land.

Among the wiring layers of the four-layer board B, at the 3/4 layer (third layer surface L3), lands L3c and L3d are provided at positions respectively corresponding to the lands L3a and L3b on the detector 3 side, and lands L4c and L4d are provided at positions respectively corresponding to the lands L4a and L4b on the differential amplifier 4 side. Then, the detection wire 5c connects the land L3c and the land L4c while detouring around the land L4d, and the detection wire 5d connects the land L3d and the land L4d while detouring around the land L3c.

Between the 2/4 layer and the 3/4 layer of the wiring layers of the four-layer board B, a through-hole H3a, a through-hole H3b, a through-hole H4a, and a through-hole H4b electrically connect the 2/4 layer and the 3/4 layer. Between the 2/4 layer and the 3/4 layer, the land L3a and the land L3c are connected via the through-hole H3a, the land L3b and the land L3d are connected via the through-hole H3b, the land L4a and the land L4c are connected via the through-hole H4a, and the land L4b and the land L4d are connected via the through-hole H4b. The lands may be regarded as parts of the through-holes.

With this configuration, the polarities of the detection wires 5 arranged in different layers (e.g., the 2/4 layer and the 3/4 layer) can be set in a staggered form. The polarities of the detection wires 5 refer to the polarities of the plus input terminal 4a and the minus input terminal 4b of the differential amplifier 4 to which the detection wires 5 are connected.

At this time, the detection wire 5c and the detection wire 5d may be arranged so as to be point-symmetric with respect to the intersection of a line connecting the land L3c and the land L4d and a line connecting the land L3d and the land L4c (i.e., the center of gravity among the land L3c, the land L3d, the land L4d, and the land L4c), and the lengths or the numbers of times of detouring of the detection wire 5c and the detection wire 5d may be equalized, for example. In this way, the wiring structure for the detection wires (here, the detection wires 5c and 5d) to be added to the detection wires 5a and 5b in the detection circuit 1 is designed in consideration of interference from the noise source, whereby it is possible to enhance the effect of reducing the influence of interference from the noise source on the detection wires 5 in the detection circuit 1.

In FIG. 4, the detection wires 5 in the detection circuit 1 are arranged at the 2/4 layer and the 3/4 layer of the four-layer board B. However, without limitation to this example, the detection wires 5 may be arranged at other layers, or the detection wires 5 may be arranged at three or more layers. That is, it suffices that, at the wiring layers of the multilayer board, a plurality of pairs of detection wires 5 are arranged so as to pass such positions that can cancel out the influence of interferences from one or more noise sources, between the detector 3 and the differential amplifier 4 in the detection circuit 1.

In addition to arrangement of the plurality of pairs of detection wires 5, the arrangement positions and lengths of the through-holes may be determined in consideration of interferences from one or more noise sources, whereby it is possible to obtain a wiring structure having a higher effect of reducing the influence of interference from electromagnetic noise. Instead of the through-holes, via-holes may be used.

That is, the detection circuit 1 of the present disclosure can be expressed as including: through-holes provided at both ends of each of the plus-side detection wire 5a and the minus-side detection wire 5b arranged at a first layer of the multilayer board; and the first detection wire 5c and the second detection wire 5d arranged at a second layer of the multilayer board electrically connected with the first layer via the through-holes, wherein both ends of the plus-side detection wire 5a are respectively connected to both ends of the first detection wire 5c via the through-holes, both ends of the minus-side detection wire 5b are respectively connected to both ends of the second detection wire 5d via the through-holes, and a pair of wires composed of the first detection wire 5c and the second detection wire 5d have equal lengths and are arranged so as to be point-symmetric with respect to a center of gravity among connection parts where the first detection wire 5c and the second detection wire 5d, and the through-holes, are connected to each other.

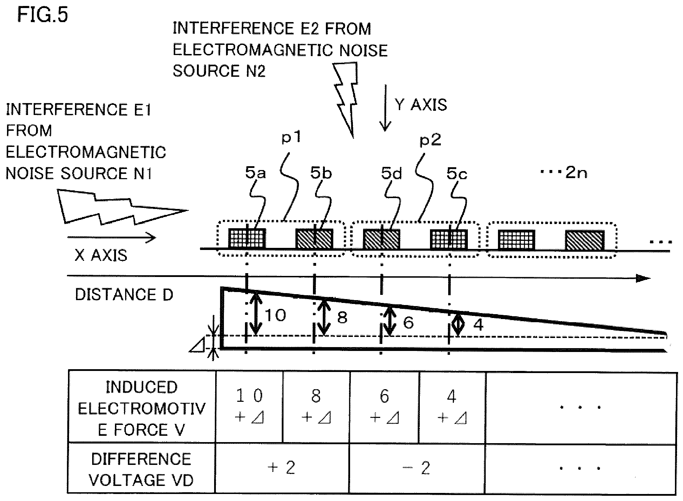

FIG. 5 is a schematic diagram schematically showing a configuration example in which the detection wires 5 of the detection circuit 1 are arranged at the same layer of the board.

At the same layer of the board, a plurality of pairs of detection wires 5 led from both ends (one end 3a and other end 3b) of the detector 3 in the detection circuit 1 are arranged. At this time, two detection wires 5 included in adjacent pairs and arranged so as to be adjacent to each other are arranged so as to be connected to the same-polarity input terminal of the differential amplifier 4. That is, of the detection wires 5 included in adjacent pairs, the detection wires 5 having a plus polarity and connected to the plus input terminal 4a of the differential amplifier 4 are arranged so as to be adjacent to each other, and the detection wires 5 having a minus polarity and connected to the minus input terminal 4b of the differential amplifier 4 are arranged so as to be adjacent to each other.

In the example in FIG. 5, detection wires 5a, 5b, 5c, 5d, ..., 5 (2n (n is a positive number)) are arranged at the same layer of the board such that a pair p1 of the detection wires 5a and 5b and a pair p2 of the detection wires 5c and 5d are adjacent to each other. Then, the detection wires 5b and 5d included in the pair p1 and the pair p2 are the detection wires 5 having a minus polarity (-polarity) and to be connected to the minus input terminal 4b (- input terminal) of the differential amplifier 4, and therefore are arranged so as to be adjacent to each other. In addition, regarding the detection wires 5a and 5c having a plus polarity (+ polarity) and to be connected to the plus input terminal 4a (+ input terminal) of the differential amplifier 4, in a case where the detection wire 5a, 5c is adjacent to a pair of detection wires 5 other than the pair p1 and the pair p2, the detection wire 5a, 5c is arranged so as to be adjacent to the detection wire 5 having the same plus polarity and included in the other pair.

In FIG. 5, a direction parallel to the board surface is defined as the X-axis direction, and a case where interferences of electromagnetic noises come in the positive directions of the X axis and the Y axis to the detection wires 5 arranged in the board, will be described. In FIG. 5, as an example of interference of electromagnetic noise, it is assumed that there are interference E1 in the positive direction of the X axis from an electromagnetic noise source N1 and interference E2 in the positive direction of the Y axis from an electromagnetic noise source N2.

Here, regarding the interference E2 in the Y-axis direction which is a direction perpendicular to the board surface, the detection wires 5a to 5d are arranged on the same plane and induced voltages due to the interference E2 are generated equally, so that the induced voltages are ideally canceled out in the differential amplifier 4.

Meanwhile, regarding the interference E1 in the X-axis direction which is a direction parallel to the board surface, where the direction of the interference E1 from the noise source N1 is the positive direction of the X axis, the magnitude order of the influences of the interference E1 on the detection wires 5a to 5d is, from the one closest to the noise source N1, the detection wire 5a > the detection wire 5b > the detection wire 5d > the detection wire 5c, and the intensity order of the induced voltages generated on the detection wires 5a to 5d is the induced voltage Va > the induced voltage Vb > the induced voltage Vd > the induced voltage Vc. In FIG. 5, an induced electromotive force V decreases in proportion to a distance D between each detection wire 5a to 5d and the noise source N1, i.e., $Va = 10 + \Delta$, $Vb = 8 + \Delta$, $Vd = 6 + \Delta$, and then $Vc = 4 + \Delta$, so that difference voltages VD are $VDab = + 2$ and $VDcd = -2$ and thus induced voltages having opposite polarities are generated. Accordingly, the induced voltages generated on the detection wires 5a to 5d become zero by being combined in the differential amplifier 4. Here, since the description is given only for the differences of the induced voltages generated on the detection wires 5a to 5d, the absolute values of the respective induced electromotive forces V are written in a simplified manner using Δ (delta).

As described above, at the same layer of the board, a plurality of pairs of detection wires 5 are arranged consecutively such that the detection wires 5 having the same polarity and included in adjacent pairs are adjacent to each other, whereby it becomes possible to cancel out the influence of interference from a noise source.

In order to obtain such an effect, the detection wires 5 are arranged so that the absolute values of the difference voltages VDab, VDbd, VDdc become equal to each other. Thus, the difference voltage VDab between the induced voltages generated on the pair of detection wires 5a and 5b has a plus polarity, the difference voltage VDcd between the induced voltages generated on the pair of detection wires 5c and 5d has a minus polarity, and the absolute values of the difference voltage VDab and the difference voltage VDcd become equal to each other, so that the induced voltages Va to Vd generated on the detection wires 5a to 5d can be canceled out with each other.

Further, as shown in FIG. 5, in an environment in which induced voltage depending on the distance D from the noise source is generated on each detection wire 5 in the detection circuit 1, in a case where wiring can be made such that the absolute values of difference voltages of a plurality of pairs of detection wires 5 are equal to each other and the polarities of difference voltages of the adjacent pairs are different from each other, not only the number of the detection wires 5 is set at a multiple of 2 but also the number of the pairs of detection wires 5 may be set at a multiple of 2. Thus, a result of combining all the difference voltages of the pairs becomes zero, so that it becomes easy to configure the cancellation effect for interference in circuit designing.

Also in FIG. 5, in order to reduce the influence of interference from electromagnetic noise on the detection circuit 1, it is desirable to arrange the detection wires 5 in the above-described manner while considering the arrangement positions of the detector 3 and the differential amplifier 4 in the detection circuit 1 mounted to the electric circuit, the specifications of the circuit board, the number of wires and a wiring space that are permitted in terms of designing, and the like.

That is, in the detection circuit 1 of the present disclosure, it can be expressed that, at the same surface of the board, a plurality of pairs composed of each detection wire 5 included in the plus-side detection wire 5a and the first detection wire 5c and each detection wire 5 included in the minus-side detection wire 5b and the second detection wire 5d are arranged in parallel, and two detection wires 5 adjacent to each other and included in two adjacent pairs among the plurality of pairs are connected to the plus input terminal 4a or the minus input terminal 4b of the differential amplifier 4.

Embodiment 2

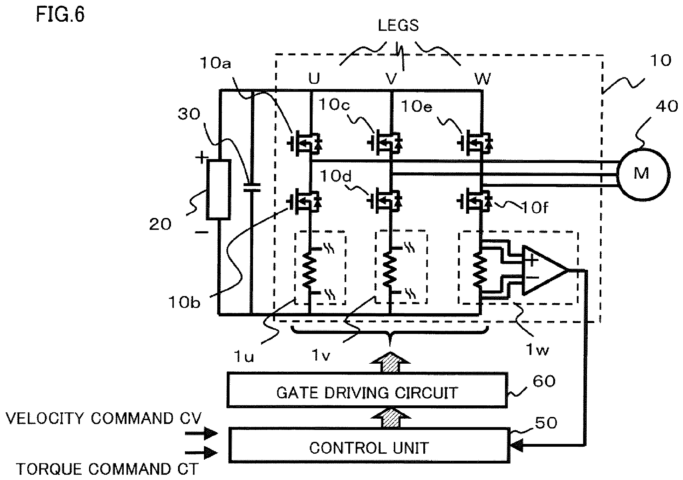

FIG. 6 is a configuration diagram showing a configuration example in which the detection circuit 1 is mounted to an inverter, according to embodiment 2 of the present disclosure. Here, description will be given using a three-phase inverter 10 as an example of the inverter.

The three-phase inverter 10 is connected to a DC voltage source 20 which is a power supply for a circuit of the three-phase inverter 10, and a motor 40 as an output destination from the circuit.

A control unit 50 controls a gate driving circuit 60 on the basis of information on a signal CV of a torque command for the motor 40, a signal CT of a velocity command therefor, and currents flowing through detection circuits 1u, 1v, 1w connected in series to the respective phases of the three-phase inverter 10, to drive the gates of switching elements 10a, 10b, 10c, 10d, 10e, 10f composing the three-phase inverter 10, thus controlling the motor 40.

In the three-phase inverter 10, the switching elements 10a, 10b with diodes connected in antiparallel thereto and the detection circuit 1u are connected in series, to form U phase. Such a configuration may be referred to as a leg. Hereinafter, a leg for U phase is referred to as a leg U.

Similarly, the switching elements 10c, 10d and the detection circuit 1v are connected in series, to form V phase (hereinafter, a leg for V phase is referred to as a leg V), and the switching elements 10e, 10f and the detection circuit 1w are connected in series, to form W phase (hereinafter, a leg for W phase is referred to as a leg W). Then, the legs U, V, W are connected in parallel to the DC voltage source 20 and the smoothing capacitor 30.

An intermediate point between the switching elements 10a, 10b connected in series in the leg U is connected to a U terminal of the motor 40, an intermediate point between the switching elements 10c, 10d connected in series in the leg V is connected to a V terminal of the motor 40, and an intermediate point between the switching elements 10e, 10f connected in series in the leg W is connected to a W terminal of the motor 40. Then, outputs of the detection circuits 1u, 1v, 1w are inputted to the control unit 50.

The configurations of the detection circuits 1u, 1v, 1w are the same as the circuit configuration using a resistor as the detector 3 as described in FIG. 1, and therefore the description thereof is omitted.

In such a circuit in which a plurality of switching elements are included and current paths are switched in accordance with switching states as in the three-phase inverter 10 shown in FIG. 6, a counter electromotive force obtained by multiplying an inductance component of the current path by current change per time is generated on the wire forming the current path. Where the inductance component is denoted by L and current change per time is denoted by di/dt, the counter electromotive force is represented as Ldi/dt, and in particular, when current is interrupted, the counter electromotive force is maximized. The counter electromotive force serves as a noise source for electromagnetic noise, and causes interference as induced voltage to the detection circuit 1.

In the three-phase inverter 10, there are a plurality of wires as current paths connecting components composing the circuit, and the inductance components L of the wires forming the current paths have various values. Thus, levels of noises (i.e., the counter electromotive forces (Ldi/dt)) caused by noise sources also have various values, and there are a plurality of noise sources of which the position relationships with the detection circuit 1 are not uniform and the noise levels change variously.

For example, while current flowing in U phase is detected by the detection circuit 1u, even in a case where there are no changes in the switching states of the switching elements 10a, 10b and therefore there is no change in U-phase current, when the switching state of any of the switching elements 10c to 10f forming V phase and W phase has changed, current change occurs with respect to the inductance component of at least any of the wires composing the three-phase inverter 10. A counter electromotive force generated on the wire due to the above current change serves as a noise source, thus causing such an influence that electromagnetic noise interferes with the detection circuit 1u for U phase.

Switching operations are performed alternately between the upper arm side and the lower arm side of the three-phase inverter 10. In a case where large current flows from the three-phase inverter 10 to the motor 40, a period in which the switching elements 10a, 10c, 10e on the upper arm side are turned on (i.e., current flows) increases, and meanwhile, a period in which the switching elements 10b, 10d, 10f on the lower arm side are turned on (i.e., current flows) decreases. Then, in FIG. 6, if a period in which currents are detected in the detection circuits 1u, 1v, 1w provided on the lower arm side decreases, current is to be detected before the influence of interference from electromagnetic noise is suppressed, so that current detection accuracy is lowered. Thus, controlling the motor 40 using information on currents flowing through the detection wires 5 of the detection circuits 1u, 1v, 1w in a state of being influenced by interference from electromagnetic noise can cause vibration or an operation malfunction.

In this regard, if the detection circuits 1u, 1v, 1w have the configuration of the present disclosure, the influence of interference from electromagnetic noise can be reduced, and as a result, an effect of suppressing lowering of accuracy in detection for current is obtained. Thus, it becomes possible to perform appropriate control for the motor 40 on the basis of accurate current detection.

That is, the inverter of the present disclosure can be expressed as including: the detection circuit 1 connected in series to each phase; an upper arm and a lower arm which alternately perform switching operations using the switching elements 10c to 10f; a gate driving circuit 60 which turns on or off the switching elements 10c to 10f; and a control unit 50 which controls the gate driving circuit 60, wherein the detection circuit 1 is connected in series to the switching element 10c to 10f in either the upper arm or the lower arm, and inputs the output of the differential amplifier 4 to the control unit 50.

Embodiment 3

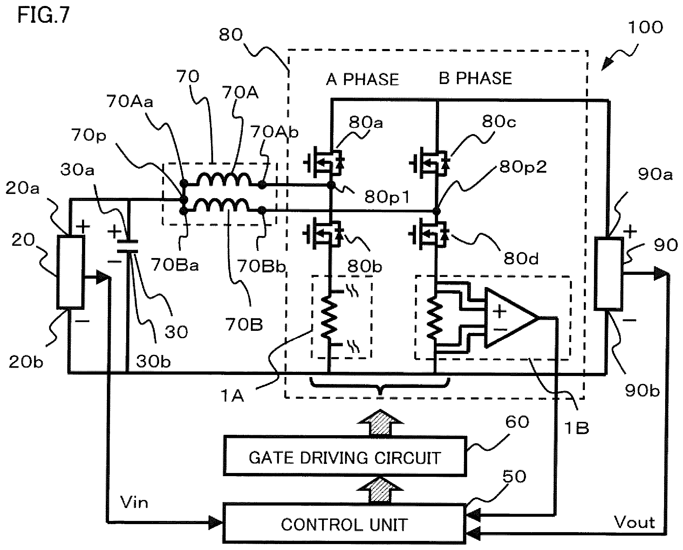

FIG. 7 is a configuration diagram showing a configuration example in which the detection circuit 1 is mounted to a boost converter, according to embodiment 3 of the present disclosure. Here, description will be given using a two-phase boost converter 100 as an example of the boost converter.

The two-phase boost converter 100 includes a DC voltage source 20, smoothing capacitors 30, 90, a control unit 50, a gate driving circuit 60, a reactor 70, and a switching circuit 80.

The DC voltage source 20 which is a power supply for the two-phase boost converter 100, and the smoothing capacitor 30, are connected in parallel.

A connection point 70p between one end 70Aa of a reactor 70A and one end 70Ba of a reactor 70B connected in parallel is connected to a positive terminal 20a of the DC voltage source 20 and a positive terminal 30a of the smoothing capacitor 30. The reactors 70A and 70B are regarded as the reactor 70.

The switching circuit 80 is formed such that an A-phase leg in which switching elements 80a, 80b and a detection circuit 1A are connected in series, a B-phase leg in which switching elements 80c, 80d and a detection circuit 1B are connected in series, and the smoothing capacitor 90, are connected in parallel.

A positive terminal 90a of the smoothing capacitor 90 is connected to the switching elements 80a, 80c, and a negative terminal 90b of the smoothing capacitor 90 is connected to the detection circuits 1A, 1B.

A connection point 80p1 between the switching elements 80a, 80b is connected to another end 70Ab of the reactor 70A, and a connection point 80p2 between the switching elements 80c, 80d is connected to another end 70Bb of the reactor 70B.

Then, the negative terminal 90b of the smoothing capacitor 90 is connected to a negative terminal 20b of the DC voltage source 20 and a negative terminal 30b of the smoothing capacitor 30.

The control unit 50 performs voltage control for obtaining desired output voltage Vout at the smoothing capacitor 90 and current control for making currents flowing through the A-phase leg and the B-phase leg equal to each other, on the basis of information on voltage Vin of the DC voltage source 20, information on voltage of the smoothing capacitor 90, information on current of the A-phase leg in the switching circuit 80 detected by the detection circuit 1A, and information on current of the B-phase leg in the switching circuit 80 detected by the detection circuit 1B. The current control at this time is performed by the control unit 50 controlling the gate driving circuit 60 and then the gate driving circuit 60 controlling and driving the gates of the switching elements 80a, 80b, 80c, 80d of the switching circuit 80.

In such a boost converter that includes the switching elements 80a, 80b and the switching elements 80c, 80d connected in parallel and forms a plurality of phases as shown in FIG. 7, control for causing currents to flow equally in the respective phases (current balance control) is performed, thereby equalizing the current densities. Thus, currents of the connected switching elements 80a to 80d are kept within the allowable range, the specifications for heat generation are satisfied, and the power density of a conversion device such as a converter is increased.

However, for example, in a case where the switching elements 80a to 80d reduced in size for a purpose such as downsizing magnetic components composing a conversion device such as a converter are driven at a high speed, a period in which currents flow through the detection circuits 1A and 1B per one switching operation decreases, and this means that the switching speed increases and current change di/dt per time increases. Thus, a counter electromotive force due to interference from a noise source increases, resulting in a problem that current flowing in each phase cannot be accurately detected.

That is, as in the inverter described in embodiment 2, also in the converter (conversion device), when the switching elements 80a to 80d are turned on or off, a counter electromotive force obtained by multiplying the inductance component of the wire composing the switching circuit 80 by current change per time is generated to be a noise source for electromagnetic noise, thus influencing the detection circuits 1A and 1B.

With the detection circuit 1 of the present disclosure, as described above, it becomes possible to accurately detect current or voltage while canceling out the influences of counter electromotive forces, in a case of performing high-speed driving of a conversion device or performing current balance control, under interference from an electromagnetic noise.

In FIG. 7, the two-phase boost converter has been described as an example. However, the number of phases of the boost converter is not limited to two. In addition, the configuration of the conversion device is not limited to a boost converter, and the same effects can be obtained as long as a shunt resistor is interposed on a current path.

That is, the conversion device of the present disclosure can be expressed as including: the detection circuit 1 connected in series to each phase; a gate driving circuit 60 which turns on or off current flowing through a reactor 70 and a capacitor 30, using switching elements 80a to 80d; and a control unit 50 which controls the gate driving circuit, wherein the detection circuit 1 is connected in series to the switching elements 80a to 80d and inputs the output of the differential amplifier 4 to the control unit 50.

In the present disclosure, a current detection circuit using a resistor on a current path as the detector 3 of the detection circuit 1 has been described as an example. However, as the detector 3 of the detection circuit 1, a capacitor may be used on a voltage path, whereby it is possible to obtain an effect of reducing the influence of interference from electromagnetic noise on a voltage detection circuit.

DESCRIPTION OF THE REFERENCE CHARACTERS

| | |
|---|---|
| 1, 1u, 1v, 1w, 1A, 1B | detection circuit |
| 2 | path (current path or voltage path) |
| 3 | detector |
| 4 | differential amplifier |
| 5 | detector |
| 5a to 5c | detection wire |
| 10 | inverter |
| 10a to 10f, 80a to 80d | switching element |
| 20 | DC voltage source |
| 30, 90 | smoothing capacitor |
| 40 | motor |
| 50 | control unit |
| 60 | gate driving circuit |
| 70, 70a, 70b | reactor |
| 80 | switching circuit |
| 100 | converter (conversion device) |

**Claims**

1. A detection circuit (1) of which wiring is made at a multilayer board (B) having at least two layers, the detection circuit (1) comprising:

   a detector (3) interposed on a path (2) of current or voltage in an electric circuit;
   a differential amplifier (4) which outputs voltage according to the current or the voltage detected by the detector (3);
   a plus-side detection wire (5a) connected between a plus input terminal (4a) of the differential amplifier (4) and one (3a) end of both ends at which the detector (3) is connected to the path;
   a minus-side detection wire (5b) connected between a minus input terminal (4b) of the differential amplifier (4) and another end (3b) of both ends;
   at least one first detection wire (5c) connected in parallel to at least a part of the plus-side detection wire (5a) between the one end of the detector (3) and the plus input terminal (4a) of the differential amplifier (4); and
   at least one second detection wire (5d) connected in parallel to at least a part of the minus-side detection wire (5b) between the other end of the detector (3) and the minus input terminal (4b) of the differential amplifier (4), wherein
   at the same layer of the multilayer board, each detection wire included in the plus-side detection wire (5a) and the first detection wire (5c) is arranged so as to be adjacent to, in a direction parallel to a surface of the multilayer board, any of detection wires included in the minus-side detection wire (5b) and the second detection wire (5d), and
   at different layers of the multilayer board, each detection wire included in the plus-side detection wire (5a) and the first detection wire (5c) is arranged so as to be opposed to, in a direction perpendicular to the surface of the multilayer board, any of detection wires included in the second detection wire (5d) and the minus-side detection wire (5b).

2. The detection circuit (1) according to claim 1, wherein

   each detection wire included in the first detection wire (5c) is paired with each detection wire included in the second detection wire (5d), and
   a total number of the plus-side detection wire (5a), the minus-side detection wire (5b), the first detection wire (5c), and the second detection wire (5d) is a multiple of 2.

3. The detection circuit (1) according to claim 1 or 2, wherein
   the first detection wire (5c) and the second detection wire (5d) are arranged so that the output voltage obtained by the differential amplifier (4) combining a first difference voltage which is a difference between the induced voltages on the plus-side detection wire (5a) and the minus-side detection wire (5b) and a second difference voltage which is a difference between the induced voltages on the first detection wire (5c) and the second detection wire (5d), becomes 0.

4. The detection circuit (1) according to any one of claims 1 to 3, wherein

   the detector (3) is a resistor, and
   a value of current or voltage present in a main circuit to which the resistor is electrically connected is detected or measured on the basis of a voltage generated between both ends when current flows through the resistor.

5. The detection circuit (1) according to any one of claims 1 to 3, wherein

   the detector (3) is a capacitor, and
   a value of current or voltage present in a main circuit to which the capacitor is electrically connected is detected or measured on the basis of a voltage stored in the capacitor.

6. An inverter comprising:

   a respective detection circuit (1) according to any one of claims 1 to 3, connected in series to each phase;
   an upper arm and a lower arm which alternately perform switching operations using switching elements (10a, 10b, 10c, 10d, 10e, 10f, 80a, 80b, 80c, 80d);
   a gate driving circuit which turns on or off the switching elements (10a, 10b, 10c, 10d, 10e, 10f, 80a, 80b, 80c, 80d); and

a control unit (50) which controls the gate driving circuit, wherein
each detection circuit (1) is connected in series to the switching element (10a, 10b, 10c, 10d, 10e, 10f, 80a, 80b, 80c, 80d) for each phase in either the upper arm or the lower arm, and inputs the output of the differential amplifier (4) to the control unit (50).

7. A conversion device comprising:

a respective detection circuit (1) according to any one of claims 1 to 3, connected in series to each phase;
a gate driving circuit which turns on or off current flowing through a reactor (70) or a smoothing capacitor, using switching elements (10a, 10b, 10c, 10d, 10e, 10f, 80a, 80b, 80c, 80d); and
a control unit (50) which controls the gate driving circuit, wherein
each detection circuit (1) is connected in series to the switching element (10a, 10b, 10c, 10d, 10e, 10f, 80a, 80b, 80c, 80d) for each phase and inputs the output of the differential amplifier (4) to the control unit (50).

**Patentansprüche**

1. Detektionsschaltung (1) dessen Verdrahtung auf einer mehrschichtigen Platine (B) mit mindestens zwei Schichten gemacht ist, wobei die Detektionsschaltung (1) umfasst:

einen Detektor (3), der auf einem Pfad (2) eines Stroms oder einer Spannung in einer elektrischen Schaltung eingeschoben ist;
einen Differenzialverstärker (4), der eine Spannung entsprechend dem Strom oder der Spannung ausgibt, der/die vom Detektor (3) detektiert wird;
einen Plus-Seiten-Detektionsdraht (5a), der zwischen einem Plus-Eingangsanschluss (4a) des Differenzialverstärkers (4) und einem (3a) Ende von beiden Enden verbunden ist, an denen der Detektor (3) zu dem Pfad verbunden ist;
einen Minus-Seiten-Detektionsdraht (5b), der zwischen einem Minus-Eingangsanschluss (4b) des Differenzialverstärkers (4) und einem anderen Ende (3b) von beiden Enden verbunden ist;
mindestens einen ersten Detektionsdraht (5c), der parallel zu mindestens einem Teil des Plus-Seiten-Detektionsdrahts (5a) verbunden ist, zwischen dem einen Ende des Detektors (3) und dem Plus-Eingangsanschluss (4a) des Differenzialverstärkers (4); und
mindestens einen zweiten Detektionsdraht (5d), der parallel zu mindestens einem Teil des Minus-Seiten-Detektionsdrahts (5b) verbunden ist, zwischen dem anderen Ende des Detektors (3) und dem Minus-Eingangsanschluss (4b) des Differenzialverstärkers (4), wobei
auf derselben Schicht der mehrschichtigen Platine, jeder in dem Plus-Seiten-Detektionsdraht (5a) und dem ersten Detektionsdraht (5c) umfassten Detektionsdraht so angeordnet ist, dass er nebeneinander ist, in einer Richtung parallel zu einer Fläche der mehrschichtigen Platine, zu einem von in dem Minus-Seiten-Detektionsdraht (5b) und dem zweiten Detektionsdraht (5d) umfassten Detektionsdrähten, und
auf anderen Schichten der mehrschichtigen Platine, jeder in dem Plus-Seiten-Detektionsdraht (5a) und dem ersten Detektionsdraht (5c) umfassten Detektionsdraht so angeordnet ist, dass er entgegengesetzt ist, in einer Richtung rechtwinklig zur Fläche der mehrschichtigen Platine, zu einem von in dem zweiten Detektionsdraht (5d) und dem Minus-Seiten-Detektionsdraht (5b) umfassten Detektionsdrähten.

2. Detektionsschaltung (1) nach Anspruch 1, wobei

jeder in dem ersten Detektionsdraht (5c) umfasster Detektionsdraht mit jedem in dem zweiten Detektionsdraht (5d) umfassten Detektionsdraht gepaart ist, und
eine Gesamtzahl des Plus-Seiten-Detektionsdrahts (5a), des Minus-Seiten-Detektionsdrahts (5b), des ersten Detektionsdrahts (5c) und des zweiten Detektionsdrahts (5d) ein Vielfaches von 2 ist.

3. Detektionsschaltung (1) nach Anspruch 1 oder 2, wobei
der erste Detektionsdraht (5c) und der zweite Detektionsdraht (5d) so angeordnet sind, dass die durch den Differenzialverstärker (4) erhaltene Ausgangsspannung 0 wird, die eine erste Differenzspannung, die eine Differenz zwischen der induzierten Spannung auf dem Plus-Seiten-Detektionsdraht (5a) und dem Minus-Seiten-Detektionsdraht (5b) ist, und eine zweite Differenzspannung, die eine Differenz zwischen der induzierten Spannung auf dem ersten Detektionsdraht (5c) und dem zweiten Detektionsdraht (5d) ist, kombiniert.

**4.** Detektionsschaltung (1) nach einem der Ansprüche 1 bis 3, wobei

der Detektor (3) ein Widerstand ist, und

ein Wert eines Stroms oder einer Spannung, der/die in einer Hauptschaltung, mit der der Widerstand elektrisch verbunden ist, detektiert oder gemessen wird, auf Grundlage einer Spannung, die zwischen beiden Enden erzeugt wird, wenn Strom durch den Widerstand fließt.

**5.** Detektionsschaltung (1) nach einem der Ansprüche 1 bis 3, wobei

der Detektor (3) ein Kondensator ist, und

ein Wert eines Stroms oder einer Spannung, der/die in einer Hauptschaltung, mit der der Kondensator elektrisch verbunden ist, detektiert oder gemessen wird, auf Grundlage einer in dem Kondensator gespeicherten Spannung.

**6.** Inverter, umfassend:

eine jeweilige Detektionsschaltung (1) nach einem der Ansprüche 1 bis 3, die in Reihe mit jeder Phase verbunden ist;

einen oberen Arm und einen unteren Arm, die abwechselnd Schaltvorgänge unter Verwendung von Schaltelementen (10a, 10b 10c, 10d, 10e, 10f, 80a, 80b, 80c, 80c) durchführen;

eine Gate-Treibschaltung, die die Schaltelemente (10a, 10b, 10c, 10d, 10e, 10f, 80a, 80b, 80c, 80d) ein- oder ausschaltet; und

eine Steuerungseinheit (50), die die Gate-Treibschaltung steuert, wobei

jede Detektionsschaltung (1) in Reiche mit dem Schaltelement (10a, 10b, 10c, 10d, 10e, 10f, 80a, 80b, 80c, 80d) für jede Phase in entweder dem oberen arm oder dem unteren Arm verbunden ist, und die Ausgabe des Differenzialverstärkers (4) an die Steuerungseinheit (50) eingibt.

**7.** Konvertierungsvorrichtung, umfassend:

eine jeweilige Detektionsschaltung nach eine der Ansprüche 1 bis 3, die in Reihe mit jeder Phase verbunden ist;

eine Gate-Treibschaltung, die einen durch einen Reaktor (70) oder einen Glättungskondensator fließenden Strom ein-oder ausschaltet, unter Verwendung von Schaltelementen (10a, 10b, 10c, 10d, 10e, 10f, 80a, 80b, 80c, 80c); und

eine Steuerungseinheit (50), die die Gate-Treibschaltung steuert; wobei

jede Detektionsschaltung (1) in Reihe mit dem Schaltelement (10a, 10b, 10c, 10d, 10e, 10f, 80a, 80b, 80c, 80d) für jede Phase verbunden ist und die Ausgabe des Differenzialverstärkers (4) an die Steuerungseinheit (50) eingibt.

**Revendications**

**1.** Circuit de détection (1) dont le câblage est réalisé au niveau d'une carte multicouche (B) comportant au moins deux couches, le circuit de détection (1) comprenant :

un détecteur (3) interposé sur un trajet (2) de courant ou de tension dans un circuit électrique ;

un amplificateur différentiel (4) qui délivre de la tension en fonction du courant ou de la tension détectés par le détecteur (3) ;

un fil de détection côté positif (5a) connecté entre une borne d'entrée positive (4a) de l'amplificateur différentiel (4) et une extrémité (3a) des deux extrémités auxquelles le détecteur (3) est connecté au trajet ;

un fil de détection côté négatif (5b) connecté entre une borne d'entrée négative (4b) de l'amplificateur différentiel (4) et l'autre extrémité (3b) des deux extrémités ;

au moins un premier fil de détection (5c) connecté en parallèle à au moins une partie du fil de détection côté positif (5a) entre l'extrémité du détecteur (3) et la borne d'entrée positive (4a) de l'amplificateur différentiel (4) ; et

au moins un deuxième fil de détection (5d) connecté en parallèle à au moins une partie du fil de détection côté négatif (5b) entre l'autre extrémité du détecteur (3) et la borne d'entrée négative (4b) de l'amplificateur différentiel (4), dans lequel

au niveau de la même couche de la carte multicouche, chaque fil de détection compris dans le fil de détection côté positif (5a) et le premier fil de détection (5c) est agencé de manière à être adjacent, dans une direction parallèle à une surface de la carte multicouche, à l'un quelconque des fils de détection compris dans le fil de détection côté négatif (5b) et le deuxième fil de détection (5d), et

au niveau de différentes couches de la carte multicouche, chaque fil de détection inclus dans le fil de détection côté positif (5a) et le premier fil de détection (5c) est agencé de manière à être opposé, dans une direction perpendiculaire à la surface de la carte multicouche, à l'un quelconque des fils de détection inclus dans le deuxième fil de détection (5d) et le fil de détection côté négatif (5b).

2. Circuit de détection (1) selon la revendication 1, dans lequel

chaque fil de détection inclus dans le premier fil de détection (5c) est apparié à chaque fil de détection inclus dans le deuxième fil de détection (5d), et

un nombre total du fil de détection côté positif (5a), du fil de détection côté négatif (5b), du premier fil de détection (5c) et du deuxième fil de détection (5d) est un multiple de 2.

3. Circuit de détection (1) selon la revendication 1 ou 2, dans lequel
le premier fil de détection (5c) et le deuxième fil de détection (5d) sont agencés de telle sorte que la tension de sortie obtenue par l'amplificateur différentiel (4) combinant une première tension différentielle qui est une différence entre les tensions induites sur le fil de détection côté positif (5a) et le fil de détection côté négatif (5b) et une deuxième tension différentielle qui est une différence entre les tensions induites sur le premier fil de détection (5c) et le deuxième fil de détection (5d), devienne 0.

4. Circuit de détection (1) selon l'une quelconque des revendications 1 à 3, dans lequel

le détecteur (3) est une résistance, et

une valeur de courant ou de tension présente dans un circuit principal auquel la résistance est connectée électriquement est détectée ou mesurée sur la base d'une tension générée entre deux extrémités lorsque le courant circule à travers la résistance.

5. Circuit de détection (1) selon l'une quelconque des revendications 1 à 3, dans lequel

le détecteur (3) est un condensateur, et

une valeur de courant ou de tension présente dans un circuit principal auquel le condensateur est connecté électriquement est détectée ou mesurée sur la base d'une tension stockée dans le condensateur.

6. Onduleur comprenant :

un circuit de détection respectif (1) selon l'une quelconque des revendications 1 à 3, connecté en série à chaque phase ;
un bras supérieur et un bras inférieur qui effectuent alternativement des opérations de commutation à l'aide d'éléments de commutation (10a, 10b, 10c, 10d, 10e, 10f, 80a, 80b, 80c, 80d) ;
un circuit de commande de grille qui active ou désactive les éléments de commutation (10a, 10b, 10c, 10d, 10e, 10f, 80a, 80b, 80c, 80d) ; et
une unité de commande (50) qui commande le circuit de commande de grille, dans lequel
chaque circuit de détection (1) est connecté en série à l'élément de commutation (10a, 10b, 10c, 10d, 10e, 10f, 80a, 80b, 80c, 80d) pour chaque phase dans soit le bras supérieur ou le bras inférieur, et transmet la sortie de l'amplificateur différentiel (4) à l'unité de commande (50).

7. Dispositif de conversion comprenant :

un circuit de détection respectif (1) selon l'une quelconque des revendications 1 à 3, connecté en série à chaque phase ;
un circuit de commande de grille qui active ou désactive le courant circulant à travers un réacteur (70) ou un condensateur de lissage, à l'aide d'éléments de commutation (10a, 10b, 10c, 10d, 10e, 10f, 80a, 80b, 80c, 80d) ; et
une unité de commande (50) qui commande le circuit de commande de grille, dans lequel
chaque circuit de détection (1) est connecté en série à l'élément de commutation (10a, 10b, 10c, 10d, 10e, 10f, 80a, 80b, 80c, 80d) pour chaque phase et transmet la sortie de l'amplificateur différentiel (4) à l'unité de commande (50).

FIG.1

FIG.2

DETECTION WIRE

| | INDUCED VOLTAGE GENERATED ON EACH DETECTION WIRE | POLARITY OF INPUT TERMINAL OF DIFFERENTIAL AMPLIFIER | INDUCED VOLTAGE INPUTTED TO DIFFERENTIAL AMPLIFIER | OUTPUT VOLTAGE OF DIFFERENTIAL AMPLIFIER |
|---|---|---|---|---|
| 5a | Va | + | (DIFFERENCE VOLTAGE HAS + POLARITY) | DIFFERENCE VOLTAGE $VD \fallingdotseq 0$ |
| 5b | Vb | − | | |
| 5c | Vc | + | (DIFFERENCE VOLTAGE HAS − POLARITY) | |
| 5d | Vd | − | | |

FIG.3

INTERFERENCE E2 FROM
ELECTROMAGNETIC NOISE SOURCE N2

Y AXIS

B

INTERFERENCE E1
FROM
ELECTROMAGNETIC
NOISE SOURCE N1

5a    5b

L1

L2

L3

L4

X AXIS

NUMBER OF
DETECTION WIRES
= 2n

5d    5c

FIG.4

## FIG.5

INTERFERENCE E2 FROM
ELECTROMAGNETIC NOISE
SOURCE N2

INTERFERENCE E1
FROM
ELECTROMAGNETIC
NOISE SOURCE N1

Y AXIS

p1    p2    ···2n

5a    5b    5d    5c

X AXIS

DISTANCE D

10    8    6    4

| INDUCED ELECTROMOTIVE FORCE V | $10 + \Delta$ | $8 + \Delta$ | $6 + \Delta$ | $4 + \Delta$ | . . . |
|---|---|---|---|---|---|
| DIFFERENCE VOLTAGE VD | $+ 2$ | | $- 2$ | | . . . |

21

FIG.6

VELOCITY COMMAND CV

TORQUE COMMAND CT

FIG.7

**REFERENCES CITED IN THE DESCRIPTION**

**Patent documents cited in the description**

- JP 6254977 B

- DE 112019004609 T5